# FASCICULE DE BREVET EUROPEEN

(11) **EP 2 943 050 B1**
(45) Date de publication et mention de la délivrance du brevet: **11.09.2019**
(21) Numéro de dépôt: 15165782.2
(22) Date de dépôt: 29.04.2015
(51) Int. Cl.: H05K 9/00

(54) **SYSTEME ELECTRIQUE AVEC BLINDAGE**
ELEKTRISCHES SYSTEM MIT ABSCHIRMUNG
ELECTRICAL SYSTEM WITH SHIELDING

(30) Priorité: 05.05.2014 FR 1454067
(43) Date de publication de la demande: 11.11.2015
(73) Titulaire: Valeo Siemens eAutomotive France SAS, 95800 Cergy (FR)
(72) Inventeur: Tramet, Guillaume, 78360 MONTESSON (FR); Colonges, Jean Baptiste, 01240 DOMPIERRE SUR VEYLE (FR)
(74) Mandataire: Argyma

(56) Documents cités:
- US-A1- 2002 024 120
- US-A1- 2012 281 386
- US-A1- 2013 014 983

## Description

### DOMAINE TECHNIQUE

La présente invention concerne le domaine du blindage électromagnétique de systèmes électriques.

### ARRIÈRE-PLAN TECHNOLOGIQUE

Il est connu de commander un module électrique de puissance au moyen d'une carte électronique disposée contre le module électrique.

Or, le module électrique émet des ondes électromagnétiques qui risquent de perturber le fonctionnement de la carte électronique.

Pour éviter ce problème, il est connu de disposer un blindage électromagnétique entre le module électrique de puissance et la carte électronique de commande. Le blindage est par exemple formé d'une feuille de métal sensiblement plane.

Le module comporte généralement une plaque conductrice formant une masse électrique pour le système électrique. Ainsi, il peut être nécessaire de connecter le blindage (et la carte électronique) à la plaque conductrice pour assurer une connexion à la masse électrique. À cet effet, il est connu d'utiliser des tiges rapportées et destinées à s'étendre depuis la carte électronique jusqu'à la plaque conductrice, en passant par le blindage.

Le document US 2002/024120 A1 divulgue un module de puissance comprenant un blindage 9 et une plaque de base conductrice 2. Le blindage 9 est disposé dans un boîtier 1 et est connecté électriquement à la plaque de base conductrice 2 par un élément de connexion conducteur 15.

L'invention a pour but de proposer un système électrique avec blindage ayant une conception simplifiée, tout en comportant une liaison, notamment une liaison électrique, entre le blindage et la plaque conductrice.

### RÉSUMÉ DE L'INVENTION

À cet effet, il est proposé un système électrique comportant :
- un module électrique comportant :
   - une plaque conductrice présentant une face supérieure,
   - un boitier présentant une face inférieure rapportée sur la face supérieure de la plaque conductrice tout en laissant au moins une partie de la face supérieure apparente,
   - des composants électriques agencés dans le boîtier,
- un blindage électromagnétique comportant un corps destiné à recouvrir au moins en partie le boîtier,
- une carte électronique de commande des composants du boîtier, destinée à recouvrir le blindage afin que le blindage protège la carte électronique des rayonnements électromagnétiques émis par les composants électriques du boîtier lors de leur fonctionnement,
le système électrique étant caractérisé en ce que le blindage comporte en outre au moins une patte venue de matière avec le corps du blindage et s'étendant vers le bas de manière à venir au contact d'une partie apparente respective.

Grâce à l'invention, l'utilisation de tiges rapportées est évitée pour relier le blindage à la plaque conductrice. Ainsi, le système électrique présente moins de pièces ce qui simplifie sa conception. En outre, le montage est simplifié puisqu'il ne comporte plus d'étape de montage des tiges.

De façon optionnelle, chaque patte comporte une extrémité présentant une face inférieure destinée à être rapportée contre la partie apparente.

De façon optionnelle également, le corps et la ou les pattes sont formés à partir d'une même feuille, par découpage et pliage de cette feuille.

De façon optionnelle également, le blindage comporte en outre au moins un bras s'étendant vers le haut depuis le corps du blindage et sur lequel la carte électronique est destinée à venir reposer.

De façon optionnelle également, le ou les bras sont également formés à partir de la feuille, par découpage et pliage de cette feuille.

De façon optionnelle également, le boîtier comporte en outre, pour chaque bras, un doigt s'élevant vers le haut, en particulier vers la carte électronique, et sur lequel le bras est destiné à venir reposer.

De façon optionnelle également, le système électrique comporte en outre une feuille isolante destinée à être intercalée entre le blindage et la carte électronique.

De façon optionnelle également, la plaque conductrice forme une masse électrique du système électrique.

De façon optionnelle également, pour chaque partie apparente de la plaque conductrice, le corps du blindage comporte une ouverture destinée à être située au-dessus de cette partie apparente.

De façon optionnelle également, le système électrique comporte en outre :
- un carter comportant :
   - un fond présentant une face supérieure contre laquelle la face inférieure de la plaque conductrice est destinée à être rapportée,
   - un couvercle muni, pour chaque partie apparente de la plaque conductrice, d'une tige s'étendant vers le bas et destinée à passer dans l'ouverture du blindage située au-dessus de cette partie apparente, la tige présentant une extrémité inférieure destinée à être rapportée contre une face supérieure de la patte du blindage destinée à venir au contact de cette partie apparente.

En particulier, le couvercle est destiné à fermer le carter.

### DESCRIPTION DES FIGURES

Des modes de réalisation de l'invention vont à présent être décrits à titre d'exemple uniquement, en référence aux figures suivantes.
La figure 1 est une vue éclatée d'un système électrique selon l'invention.
La figure 2 est une vue en coupe de côté du système électrique de la figure 1.

### DESCRIPTION DÉTAILLÉE

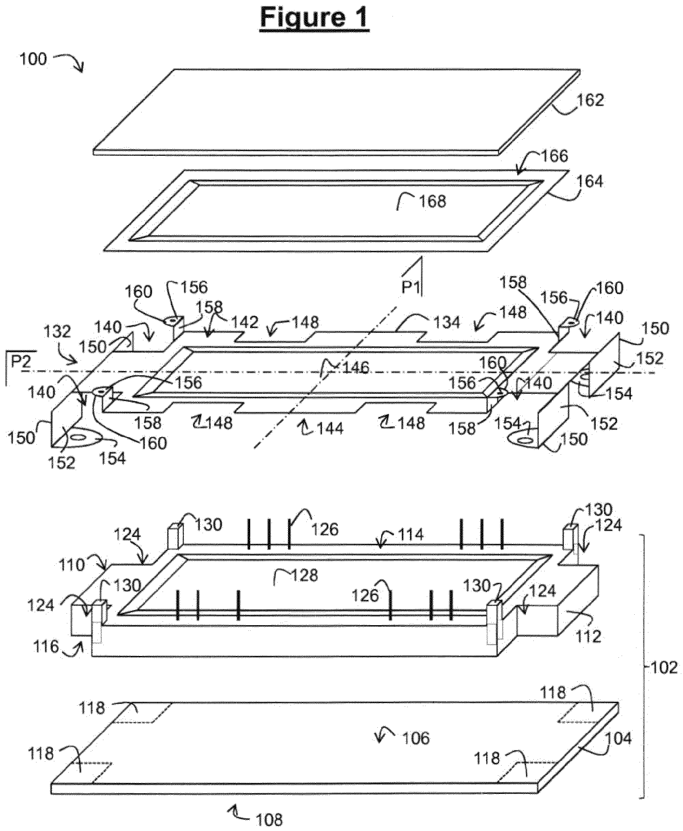

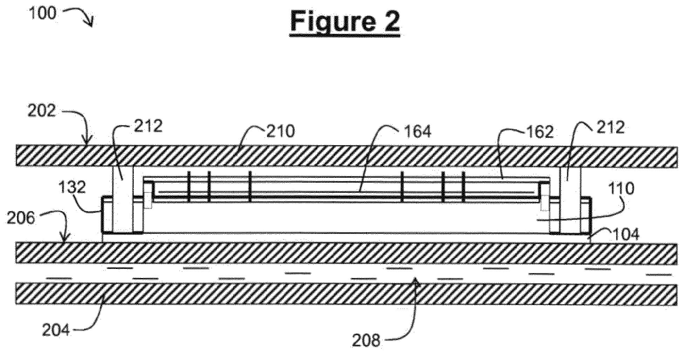

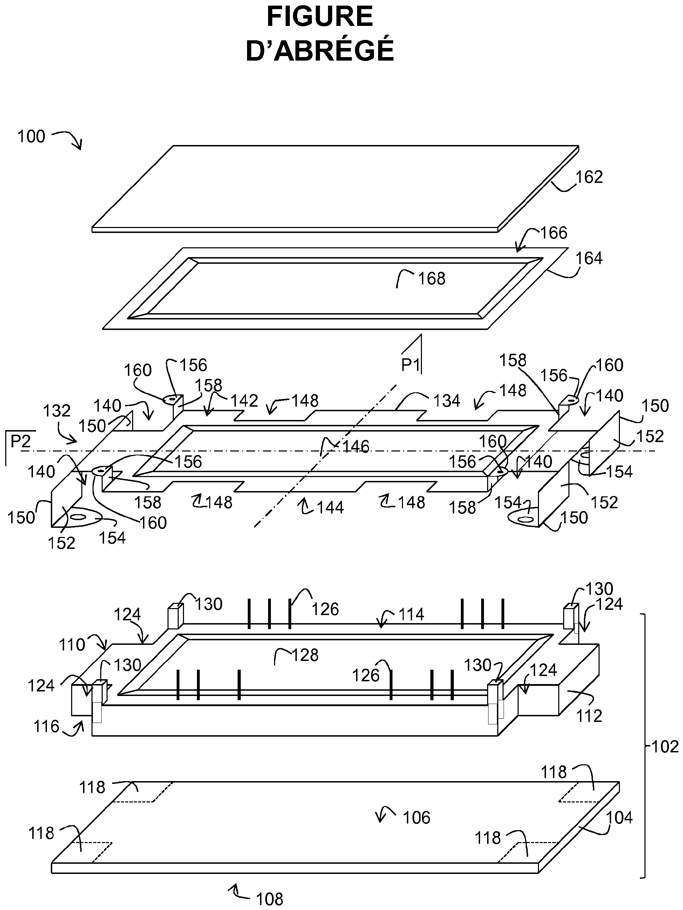

En référence aux figures 1 et 2, un système électrique 100 selon l'invention va à présent être décrit.

En référence à la figure 1, le système électrique 100 comporte tout d'abord un module électrique 102. Le module électrique est par exemple un module électrique de puissance, c'est-à-dire parcouru par un courant de 1 ampère ou plus. Le système électrique 100 est par exemple compris dans un onduleur ou plus généralement dans un convertisseur de tension.

Le module électrique 102 comporte tout d'abord une plaque conductrice 104 présentant une face supérieure 106 et une face inférieure 108. La plaque conductrice 104 est plane et rectangulaire, et présente par exemple une épaisseur comprise entre 1 et 5 millimètres. La plaque conductrice 104 est destinée à constituer une masse électrique du système électrique 100. La plaque conductrice 104 peut être en métal, par exemple en nickel ou en cuivre.

Le module électrique 102 comporte en outre un boîtier 110 isolant fixé à la plaque conductrice 104.

Le boîtier 110 comporte un corps 112 présentant une face supérieure 114 et une face inférieure 116 rapportée sur la face supérieure 106 de la plaque conductrice 104. Le boîtier 110 laisse apparente au moins une partie 118 de la face supérieure 106. Ces parties apparentes 118 sont donc la ou les parties de la face supérieure 106 qui sont libres du boîtier 110.

Dans l'exemple décrit, le corps 112 du boîtier 110 comporte une partie centrale et deux avancées sur deux côtés opposés de la partie centrale, de manière à définir quatre ouvertures 124 laissant apparents les quatre coins de la face supérieure 106 de la plaque conductrice 104.

Des composants électriques (non représentés) sont agencés dans le boîtier 110. Dans l'exemple décrit, le boîtier 110 renferme les composants électriques. Ces composants électriques sont connectés à des broches 126 sortant de la face supérieure 114 du boîtier 110 (par soucis de clarté, seules deux broches sont référencées sur la figure 1). Les composants électriques sont en outre connectés à la plaque conductrice 104, en particulier pour une liaison à la masse. Les composants électriques sont par exemple des composants de puissance, c'est-à-dire pouvant être parcourus par des courants d'1 Ampère ou plus.

Un renfoncement 128 est en outre ménagé dans la face supérieure 114 du boîtier 110.

Le boîtier 110 comporte en outre au moins un doigt 130 s'étendant vers le haut, c'est-à-dire vers la carte électronique 162 qui sera décrite plus loin, depuis la partie centrale du corps 112 du boîtier 110.

Le système électrique 100 comporte en outre un blindage 132.

Le blindage 132 comporte un corps 134 plat et destiné à recouvrir au moins en partie la face supérieure 114 du boîtier 110.

Dans l'exemple décrit, le corps 134 du blindage 132 comporte, d'une manière similaire au corps 112 du boîtier 110, une partie centrale et deux avancées sur deux côtés opposés de la partie centrale, de manière à définir, pour chaque partie apparente 118 de la face supérieure 106 de la plaque conductrice 104, une ouverture 140 située au-dessus de de cette partie apparente 118 (et donc également au-dessus de l'ouverture 124 du boîtier 110 pour cette partie apparente 118).

Le corps 134 du blindage 132 comporte une face supérieure 142 et une face intérieure 144 en vis-à-vis de la face supérieure 114 du boîtier 110. Un renfoncement 146 est ménagé dans la face supérieure 142 du blindage 132. Des échancrures 148 sont en outre ménagées dans la partie centrale du corps 134 du blindage 132 pour permettre le passage des broches 126 du boîtier 110.

Le blindage 132 comporte en outre, pour chaque partie apparente 118 de la face supérieure 106 de la plaque conductrice 104, une patte 150 venue de matière avec le corps 134 du blindage 132 et s'étendant vers le bas de manière à venir au contact de cette partie apparente 118. Dans l'exemple décrit, chaque patte 150 comporte une jambe 152 verticale. Chaque patte 150 comporte en outre, en bas de la jambe 152, c'est-à-dire à la portion distale de la jambe 152 qui n'est pas liée au corps 134, une extrémité 154 s'étendant horizontalement, c'est-à-dire parallèlement à la face supérieure de la plaque conductrice 104, en direction de la partie centrale du corps 134 du blindage 132. L'extrémité 154 présente une face supérieure en vis-à-vis de l'ouverture 140 et une face inférieure destinée à être rapportée contre la partie apparente 118. Par ailleurs, un trou de fixation est ménagé dans l'extrémité 154.

Le blindage 132 comporte en outre, pour chaque doigt 130 du boîtier 110, un bras 156 s'étendant vers le haut, c'est-à-dire vers la carte électronique 162 qui sera décrite plus loin, le bras 156 étant venu de matière avec le corps 134 du blindage 132 et destiné à venir reposer sur le doigt 130 du boîtier 110. Dans l'exemple décrit, chaque bras 156 comporte un montant 158 vertical et une extrémité 160 s'étendant horizontalement, cette extrémité 160 présentant une face inférieure destinée à reposer sur le doigt 130 du boîtier 110 associé, et une face supérieure destinée à recevoir une carte électronique.

Dans l'exemple décrit, le corps 134, les pattes 150 et les bras 156 du blindage 124 sont formés à partir d'une même feuille, par découpage et pliage de cette feuille. La feuille présente par exemple une épaisseur comprise entre 0,5 et 1 millimètre.

En particulier, la jambe 152 de chaque patte 150 est obtenue par pliage du bout d'une des avancées du corps 134 du blindage 132 et l'extrémité 154 est obtenue par pliage du bout inférieur de la jambe 152.

Le montant 158 de chaque bras 156 est obtenu par pliage d'une languette attachée à la partie centrale du corps 134 du blindage 132, et l'extrémité 160 du bras 156 par pliage du bout du montant 158.

Le blindage 132 présente de préférence une symétrie planaire par rapport à un ou deux des plans verticaux avant-arrière P1 et droite-gauche P2.

Le système électrique 100 comporte en outre une carte électronique 162 de commande des composants du boîtier 110. La carte électronique 162 est destinée à venir reposer sur les bras 156 du blindage 132 pour recouvrir le blindage 132. Les broches 126 sont destinées à atteindre la carte électronique 162 pour être connectées à la carte électronique 162, afin de permettre à la carte électronique 162 de commander les composants du boîtier 110 par les broches 126.

Le blindage 132 protège la carte électronique 162 des rayonnements électromagnétiques émis par les composants électriques du boîtier 110 lors de leur fonctionnement. Par exemple, le blindage permet de diminuer de 50% ces rayonnements électromagnétiques sur la carte électronique 162. Le blindage 132 est par exemple en acier.

Le système électrique 100 comporte en outre une plaque isolante 164 intercalée entre le blindage 132 et la carte électronique 162. La plaque isolante 164 est par exemple en matière plastique. La plaque isolante 164 comporte une face supérieure 166, orientée vers la carte électronique 162, dans laquelle un renfoncement 168 est ménagé.

En référence à la figure 2, le système électrique 100 comporte en outre un carter 202 comportant un fond 204 présentant une face supérieure 206 contre laquelle la face inférieure 108 de la plaque conductrice 104 est rapportée.

Une conduite 208 est ménagée dans le fond 204 du carter 202, en particulier en-dessous de la plaque conductrice 104. Un liquide de refroidissement, comme de l'eau, est destiné à parcourir cette conduite pour refroidir le fond 204 du carter 202.

Le carter 202 comporte en outre un couvercle 210 muni, pour chaque partie apparente 118 de la face supérieure 106 de la plaque conductrice 104, une tige 212 s'étendant vers le bas, c'est-à-dire vers la plaque conductrice 104, depuis une face inférieure de la paroi supérieure 210. Chaque tige 212 est destinée à passer à côté de la carte électronique 162, puis par les ouvertures du corps du blindage et du boîtier situées au-dessus de cette partie apparente 118. La tige 212 présente une extrémité inférieure destinée à être rapportée contre la face supérieure de la patte rapportée contre cette partie apparente 118. La ou les tiges 212 servent à maintenir en place le blindage 132.

Dans l'exemple décrit, chaque tige 212 est percée de manière à former un manchon destiné à recevoir une vis par le dessus du couvercle, la vis s'étendant jusque dans la plaque conductrice et dans le fond du carter. De préférence, la plaque conductrice 104 n'est pas perforée avant l'assemblage du couvercle 210 sur la plaque conductrice 104. Dans ce cas, une vis auto foreuse peut être utilisée.

Grâce à l'invention précédente, le montage du blindage est simplifié car une seule pièce sert au blindage et à la connexion à la plaque conductrice formant masse électrique.

Par ailleurs, la présence des renfoncements 128, 146, 168 permet de disposer des composants de grande taille sur une face inférieure de la carte électronique 162.

Par ailleurs, les pattes 132 permettent de connecter le blindage à la plaque conductrice 104, et les bras 156 permettent de connecter la carte électronique 162 à la plaque conductrice 104 par l'intermédiaire du blindage 132. La plaque conductrice 104 formant la masse électrique du système électrique 100, une connexion simple du blindage 132 et de la carte électronique 162 à la masse électrique est réalisée.

La présente invention n'est pas limitée aux modes de réalisation décrits précédemment, mais est au contraire définie par les revendications qui suivent. Il sera en effet apparent à l'homme du métier que des modifications peuvent y être apportées.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

### Liste des références :

- 100: système électrique
- 102: module électrique
- 104: plaque conductrice
- 106: face supérieure de la plaque conductrice 104
- 108: face inférieure de la plaque conductrice 104
- 110: boîtier
- 112: corps du boîtier 110
- 114: face supérieure du boîtier 110
- 116: face inférieure du boîtier 110
- 118: partie apparente de la plaque conductrice 104
- 124: ouvertures du boîtier 110
- 126: broches
- 128: renfoncement du boîtier 110
- 130: doigts du boîtier 110
- 132: blindage
- 134: corps du blindage 132
- 140: ouvertures du blindage 132
- 142: face supérieure du blindage 132
- 144: face inférieure du blindage 132
- 146: renfoncement du blindage 132
- 148: échancrures du blindage 132
- 150: pattes du blindage 132
- 152: jambes des pattes 150
- 154: extrémités des pattes 150
- 156: bras du blindage 132
- 158: montants des bras 156
- 160: extrémités des bras
- 162: carte électronique
- 164: plaque isolante
- 166: face supérieure de la plaque isolante 164
- 168: renfoncement de la plaque isolante 164

- 202: carter
- 204: fond du carter 202
- 206: face supérieure du fond 204
- 208: conduite de liquide de refroidissement
- 210: couvercle du carter 202
- 212: tiges du carter 202

## Revendications

1. Système électrique (100) comportant :
- un module électrique (102) comportant :
- une plaque conductrice (104) présentant une face supérieure (106),
- un boitier (110) présentant une face inférieure (116) rapportée sur la face supérieure (106) de la plaque conductrice (104) tout en laissant au moins une partie (118) de la face supérieure (106) apparente,
- des composants électriques agencés dans le boîtier (110),
- un blindage électromagnétique (132) comportant un corps (134) destiné à recouvrir au moins en partie le boîtier (110),
- une carte électronique (162) de commande des composants du boîtier (110), destinée à recouvrir le blindage (132) afin que le blindage (132) protège la carte électronique (162) des rayonnements électromagnétiques émis par les composants électriques du boîtier (110) lors de leur fonctionnement,
le système électrique (100) étant **caractérisé en ce que** le blindage (132) comporte en outre au moins une patte (150) venue de matière avec le corps (134) du blindage (132) et s'étendant vers le bas de manière à venir au contact d'une partie apparente (118) respective.

2. Système électrique (100) selon la revendication 1, dans lequel chaque patte (150) comporte une extrémité (154) présentant une face inférieure destinée à être rapportée contre la partie apparente (118).

3. Système électrique (100) selon la revendication 1 ou 2, dans lequel le corps (134) et la ou les pattes (150) sont formés à partir d'une même feuille, par découpage et pliage de cette feuille.

4. Système électrique (100) selon l'une quelconque des revendications 1 à 3, dans lequel le blindage (132) comporte en outre au moins un bras (156) s'étendant vers le haut depuis le corps (134) du blindage (132) et sur lequel la carte électronique (162) est destinée à venir reposer.

5. Système électrique (100) selon les revendications 3 et 4, dans lequel le ou les bras (156) sont également formés à partir de la feuille, par découpage et pliage de cette feuille.

6. Système électrique (100) selon la revendication 4 ou 5, dans lequel le boîtier (110) comporte en outre, pour chaque bras (156), un doigt (130) s'élevant vers le haut et sur lequel le bras (156) est destiné à venir reposer.

7. Système électrique (100) selon l'une quelconque des revendications 1 à 6, comportant en outre une feuille isolante (164) destinée à être intercalée entre le blindage (132) et la carte électronique (162).

8. Système électrique (100) selon l'une quelconque des revendications 1 à 7, dans lequel la plaque conductrice (104) forme une masse électrique du système électrique (100).

9. Système électrique (100) selon l'une quelconque des revendications 1 à 8, dans lequel, pour chaque partie apparente (118) de la plaque conductrice (104), le corps (134) du blindage (132) comporte une ouverture (140) destinée à être située au-dessus de cette partie apparente (118).

10. Système électrique (100) selon les revendications 2 et 9, comportant en outre un carter (202) comprenant :
- un fond (204) présentant une face supérieure (206) contre laquelle la face inférieure (108) de la plaque conductrice (104) est destinée à être rapportée ;
- un couvercle (210) muni, pour chaque partie apparente (118) de la plaque conductrice (104), d'une tige (212) s'étendant vers le bas et destinée à passer dans l'ouverture (140) du blindage (132) située au-dessus de cette partie apparente (118), la tige (212) présentant une extrémité inférieure destinée à être rapportée contre une face supérieure de la patte (150) du blindage (132) destinée à venir au contact de cette partie apparente (118).

## Patentansprüche

1. Elektrisches System (100), aufweisend:
- ein elektrisches Modul (102), aufweisend:
- eine Leiterplatte (104), aufweisend eine Oberseite (106),
- ein Gehäuse (110), aufweisend eine auf der Oberseite (106) der Leiterplatte (104) angebrachte Unterseite (116), wobei dabei mindestens ein Teil (118) der Oberseite (106) sichtbar bleibt,
- elektrische Komponenten, die in dem Gehäuse (110) eingerichtet sind,
- eine elektromagnetische Abschirmung (132), aufweisend einen Körper (134), der bestimmt ist, das Gehäuse (110) mindestens zum Teil abzudecken,
- eine elektronische Karte (162) zum Steuern der Komponenten des Gehäuses (110), die zum Abdecken der Abschirmung (132) bestimmt ist, damit die Abschirmung (132) die elektronische Karte (162) vor den elektromagnetischen Strahlungen schützt, die von den elektrischen Komponenten des Gehäuses (110) bei ihrem Betrieb gesendet werden,
wobei das elektrische System (100) **dadurch gekennzeichnet ist, dass** die Abschirmung (132) ferner mindestens eine Lasche (150) aufweist, die mit dem Körper (134) der Abschirmung (132) einstückig ist und sich derart nach unten erstreckt, dass sie mit einem jeweiligen sichtbaren Teil (118) in Kontakt kommt.

2. Elektrisches System (100) nach Anspruch 1, wobei jede Lasche (150) ein Ende (154) aufweist, welches eine Unterseite aufweist, die zum Anbringen an dem sichtbaren Teil (118) bestimmt ist.

3. Elektrisches System (100) nach Anspruch 1 oder 2, wobei der Körper (134) und die Lasche(n) (150) aus einem selben Blatt durch Schneiden und Falten dieses Blatts gebildet ist/sind.

4. Elektrisches System (100) nach einem der Ansprüche 1 bis 3, wobei die Abschirmung (132) ferner mindestens einen Arm (156) aufweist, der sich ab dem Körper (134) der Abschirmung (132) nach oben erstreckt und auf dem die elektronische Karte (162) bestimmt ist, in Auflage zu kommen.

5. Elektrisches System (100) nach den Ansprüchen 3 und 4, wobei der Arm oder die Arme (156) ebenfalls aus dem Blatt durch Schneiden und Falten dieses Blatts gebildet ist/sind.

6. Elektrisches System (100) nach Anspruch 4 oder 5, wobei das Gehäuse (110) ferner für jeden Arm (156) einen Finger (130) aufweist, der sich nach oben erstreckt und auf dem der Arm (156) bestimmt ist, in Auflage zu kommen.

7. Elektrisches System (100) nach einem der Ansprüche 1 bis 6, aufweisend ferner ein isolierendes Blatt (164), das bestimmt ist, zwischen der Abschirmung (132) und der elektronischen Karte (162) zwischengestellt zu sein.

8. Elektrisches System (100) nach einem der Ansprüche 1 bis 7, wobei die Leiterplatte (104) eine elektrische Masse des elektrischen Systems (100) bildet.

9. Elektrisches System (100) nach einem der Ansprüche 1 bis 8, wobei für jeden sichtbaren Teil (118) der Leiterplatte (104) der Körper (134) der Abschirmung (132) eine Öffnung (140) aufweist, die bestimmt ist, sich über diesem sichtbaren Teil (118) zu befinden.

10. Elektrisches System (100) nach den Ansprüchen 2 und 9, aufweisend ferner einen Kasten (202), aufweisend:
- einen Boden (204), der eine Oberseite (206) aufweist, an der die Unterseite (108) der Leiterplatte (104) bestimmt ist, angebracht zu sein,
- eine Abdeckung (210), die für jeden sichtbaren Teil (118) der Leiterplatte (104) mit einem Stab (212) ausgerüstet ist, der sich nach unten erstreckt und bestimmt ist, in die Öffnung (140) der Abschirmung (132) hineinzureichen, die sich über diesem sichtbaren Teil (118) befindet, wobei der Stab (212) ein unteres Ende aufweist, das zum Anbringen an einer Oberseite der Lasche (150) der Abschirmung (132) bestimmt ist, die bestimmt ist, mit diesem sichtbaren Teil (118) in Kontakt zu treten.

## Claims

1. Electrical system (100) comprising:
- an electrical module (102) comprising:
- a conductive plate (104) having an upper face (106),
- a housing (110) having a lower face (116) which is positioned on the upper face (106) of the conductive plate (104) while leaving at least one part (118) of the upper face (106) exposed,
- electrical components arranged in the housing (110),
- an electromagnetic shielding (132) comprising a body (134) designed to cover at least part of the housing (110),
- an electronic board (162) for controlling the components of the housing (110), designed to cover the shielding (132) so that the shielding (132) protects the electronic board (162) from electromagnetic radiation emitted by the electrical components of the housing (110) during their operation,
the electrical system (100) being **characterized in that** the shielding (132) further comprises at least one leg (150) which is formed in one piece with the body (134) of the shielding (132) and extends downwards such that it comes into contact with a respective exposed part (118).

2. Electrical system (100) according to claim 1, in which each leg (150) comprises an end (154) having a lower face which is designed to be positioned against the exposed part (118).

3. Electrical system (100) according to claim 1 or 2, in which the body (134) and the leg or legs (150) are formed from a single sheet by cutting and folding this sheet.

4. Electrical system (100) according to any of claims 1 to 3, in which the shielding (132) further comprises at least one arm (156) which extends upwards from the body (134) of the shielding (132) and on which the electronic board (162) is designed to come to rest.

5. Electrical system (100) according to claims 3 and 4, in which the arm or arms (156) are also formed from the sheet by cutting and folding this sheet.

6. Electrical system (100) according to claim 4 or 5, in which the housing (110) further comprises, for each arm (156), a finger (130) which rises upwards and on which the arm (156) is designed to come to rest.

7. Electrical system (100) according to any of claims 1 to 6, further comprising an insulating sheet (164) which is designed to be interposed between the shielding (132) and the electronic board (162).

8. Electrical system (100) according to any of claims 1 to 7, in which the conductive plate (104) forms an electrical earth of the electrical system (100).

9. Electrical system (100) according to any of claims 1 to 8, in which, for each exposed part (118) of the conductive plate (104), the body (134) of the shielding (132) comprises an opening (140) which is designed to be situated above this exposed part (118).

10. Electrical system (100) according to claims 2 and 9, further comprising a casing (202) comprising:
- a base (204) having an upper face (206) against which the lower face (108) of the conductive plate (104) is designed to be positioned;
- a cover (210) provided with, for each exposed part (118) of the conductive plate (104), a rod (212) which extends downwards and is designed to pass into the opening (140) of the shielding (132), which opening is situated above this exposed part (118), the rod (212) having a lower end designed to be positioned against an upper face of the leg (150) of the shielding (132), which leg (150) is designed to come into contact with this exposed part (118).
